(19) Europäisches Patentamt
European Patent Office
Office européen des brevets

(11) **EP 2 398 150 B1**

(12) **EUROPÄISCHE PATENTSCHRIFT**

(45) Veröffentlichungstag und Bekanntmachung des Hinweises auf die Patenterteilung:
**07.10.2020 Patentblatt 2020/41**

(51) Int Cl.:
***H03M 13/29*** *(2006.01)*          ***H04L 1/00*** *(2006.01)*

(21) Anmeldenummer: **11000798.6**

(22) Anmeldetag: **01.02.2011**

(54) **Verfahren und Vorrichtung zur Übertragung eines Datenstroms aus Blöcken mit jeweils einer unterschiedlichen Symbolanzahl**

Method and device for transmitting a data flow using blocks, each with a different number of symbols

Procédé et dispositif de transmission d'un flux de données à partir de blocs systématiquement dotés d'une quantité de symboles différente

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **16.06.2010 DE 102010024043**
**02.08.2010 DE 102010033067**

(43) Veröffentlichungstag der Anmeldung:
**21.12.2011 Patentblatt 2011/51**

(73) Patentinhaber: **Rohde & Schwarz GmbH & Co. KG**
**81671 München (DE)**

(72) Erfinder:
• **Schäfer, Andrew**
**81377 München (DE)**
• **Volyanskiy, Mikhail**
**86150 Augsburg (DE)**
• **Detert, Thorben**
**80634 München (DE)**

(74) Vertreter: **Körfer, Thomas**
**Mitscherlich PartmbB**
**Patent- und Rechtsanwälte**
**Postfach 33 06 09**
**80066 München (DE)**

(56) Entgegenhaltungen:
**EP-A2- 2 136 523**

• **KHALED A. S. ABDEL-GHAFFAR, MARIO BLAUM, JOS H. WEBER,: "Analysis of Coding Schemes for Modulation and Error Control", IEEE TRANSACTIONS ON INFORMATION THEORY,, Bd. 41, Nr. 6, 30. November 1995 (1995-11-30), XP002626167,**

**Beschreibung**

Die Erfindung betrifft ein Verfahren und eine Vorrichtung zur Übertragung eines Datenstroms aus Blöcken mit jeweils einer unterschiedlichen Symbolanzahl.

In frequenzveränderlichen Übertragungskanälen werden die von einem oder mehreren Nutzern des Übertragungskanals zu übertragenden Daten im Wechsel mehreren Blöcken aus jeweils einer konstanten Anzahl von Datensymbolen zugewiesen, die jeweils in einer unterschiedlichen Frequenz übertragen werden (sogenanntes FrequenzsprungVerfahren). Im Mittel erhöht sich auf diese Weise die Ausfallsicherheit (Diversität) der einem Nutzer oder mehreren Nutzern jeweils zugewiesenen Übertragungskapazität. Auch kann auf diese Weise der Signal-Rausch-Abstand einer Übertragung in einem frequenzveränderlichen Übertragungskanal optimiert werden.

Der Wechsel zwischen den einzelnen Frequenzen im Frequenzsprungverfahren erfolgt nach einer bestimmten stochastischen Gesetzmäßigkeit, die sowohl dem Sender als auch dem Empfänger des Übertragungssystems bekannt ist, während sie einem Dritten nicht zugänglich ist.

Die technischen Zusammenhänge eines derartigen Block-Ausfall-Kanals können dem Fachartikel A. Guillen I Fabregas: "Coded Modulation in the Block-Fading Channel: Coding Theorems and Code Construction" in IEEE Transactions on Information Theory, Vol. 52, No. 1, Januar 2006, Seiten 91-144, entnommen werden.

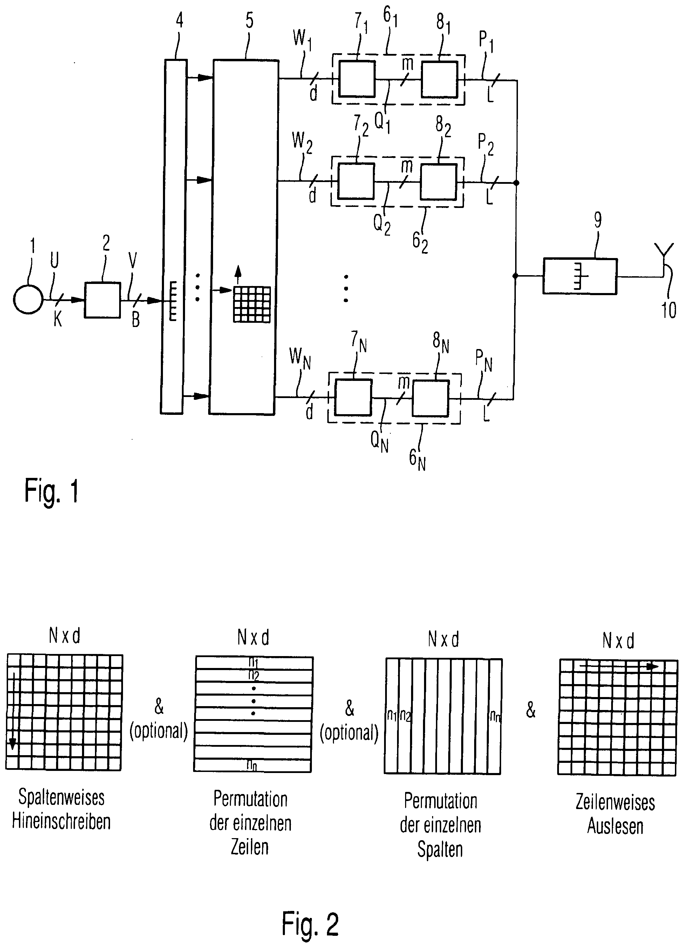

Ein vereinfachtes Blockdiagramm einer Senderstufe für die Übertragung in einem Block-Ausfall-Kanal ist in Fig. 1 dargestellt:

Eine Informationsquelle 1 erzeugt eine unkodierte Folge $U$ von zu übertragenden Datenbits. Ein äußerer Kodierer 2, typischerweise ein Blockkodierer, erzeugt aus aufeinander folgenden unkodierten Datenworten mit jeweils $K$ Datenbits der unkodierten Folge $U$ von zu übertragenden Datenbits zugehörige kodierte Datenworte mit jeweils $B$ Datenbits für eine kodierte Folge $V$ von Datenbits. In einem Demultiplexer 4 und einen Verschachtler (Interleaver) 5 werden die insgesamt $B$ Datenbits jedes kodierten Datenworts der kodierten Folge $V$ von Datenbits nach einer Verschachtelung der einzelnen Datenbits auf insgesamt $N$ Blöcke mit jeweils $d$ Datenbits verteilt. Die insgesamt $d$ Datenbits eines Blockes in einem Datenstrom $W_i$ werden in einer zum jeweiligen Block $i$ gehörigen Funktionseinheit $6_i$, die jeweils aus einem inneren Kodierer $7_i$ und einem Modulator $8_i$ besteht, in mindestens ein zugehöriges inneres Kode-Wort - typischerweise ein inneres Kode-Wort - eines Datenstroms $Q_i$ mit jeweils $m$ Datenbits kodiert und in jeweils insgesamt $L$ Datensymbole gepackt und auf ein Trägersignal $P_i$ in einer zum jeweiligen Block gehörigen Trägerfrequenz moduliert. In einem anschließenden Multiplexer 9 wird das gesamte Übertragungssignal aus den insgesamt $N$ zu jeweils einem Block gehörigen Trägersignalen $P_1, P_2, .., P_i, .., P_N$ zuzüglich der auf jedem Trägersignal jeweils modulierten $L$ Datensymbole zusammengesetzt und einer Antenne 10 zur Ausstrahlung zugeführt.

Durch die äußere Kodierung ist gewährleistet, dass bei Ausfall eines Blockes während der Übertragung aufgrund von beispielsweise Schwund (fading) im Frequenzbereich der zum ausgefallenen Block gehörigen Trägerfrequenz die Nutz-Datenbits des ausgefallenen Blocks nach dem Entschachteln (Deinterleaving) und äußeren Dekodieren rekonstruiert werden können.

Zwischenzeitlich ist es möglich, die einzelnen beim Frequenzsprungverfahren verwendeten Frequenzen sowie die in den einzelnen Frequenzen verwendeten Blocklängen durch Dritte zu detektieren. Daneben ist die gezielte Störung von Daten, die in einem am Ende jeder Blocklänge befindlichen Zeitfenster übertragen werden, durch Dritte zwischenzeitlich realistisch. Um die Störsicherheit bei einem Block-Ausfall-Kanal zu erhöhen, werden zusätzlich die Längen der bei jeder Frequenz jeweils übertragenen Blöcke ebenfalls nach einer bestimmten stochastischen Gesetzmäßigkeit variiert.

Dabei wird bei Variation der Blocklänge dem jeweiligen Block eine der Blocklänge entsprechende Anzahl von Datenbits zugewiesen. Im Fall, dass den einzelnen Blöcken eine veränderliche Anzahl von Datenbits zugewiesen wird, können durch den äußeren Dekodierer aus dem empfangenen Kode-Wort, das die Daten aller Blöcke enthält, bei Ausfall eines Blockes während der Übertragung die zum ausgefallenen Block gehörigen Nutz-Datenbits nachteilig nicht mehr exakt rekonstruiert werden.

Khaled A.S. et al beschreibt in "Analysis of Coding Schemes for Modulation and Error Control", IEEE Transactions of Information Theory, Vol. 41, No. 6, Nov. 1995, einen senderseitig ersten Kodierer und einen Reed-Solomon-Kodierer, der kodierte Datensymbole mit jeweils m Datenbits erzeugt. In einem anschließenden Verschachtler werden die kodierten Datensymbole verschachtelt und somit wird eine Sequenz von jeweils kodierten Datensymbolen erzeugt. In einem anschließenden zweiten Kodierer, einem inneren Kodierer, wird ein Daten-Rahmen erzeugt. Empfängerseitig wird die empfangene Sequenz von kodierten Datensymbolen in jeweils Einzelsequenzen mit jeweils einem kodierten Datensymbol zerlegt. Nach einer Dekodierung und einer Entschachtelung liegen wieder die Daten-Worte mit ihren Datensymbolen vor.

Die EP 2 136 523 A2 zeigt eine Vorrichtung zum Senden eines Datenstroms in einem Mehr-Träger-Übertragungssignal. Der zu übertragende Datenstrom wird einem äußeren Kanalkodierer zugeführt. Die kodierten Daten werden durch einen nachgeschalteten Verschachtler so verteilt, dass eine bestmögliche Verteilung des redundanten Informationsgehaltes erreicht wird. Ein inverser Multiplexer teilt die zu übertragenden kodierten und verschachtelten Datenbits auf einzelne Datenströme auf. Die einzelnen Datenströme werden jeweils durch einzelne innere Kodierer und jeweils einzelnen Modulatoren in Subträgersignale, die den Blöcken mit einer bestimmten Anzahl von Datensymbolen entsprechen, transformiert. Ein Addierer fügt die Subträgersignale zusammen und leitet sie an einen Übertragungskanal weiter.

Aufgabe der Erfindung ist es, ein Verfahren und eine Vorrichtung zur Übertragung von Daten in Blöcken unterschiedlicher Blocklänge in einem Block-Ausfall-Kanal mit einer optimierten Ausfallsicherheit zu schaffen.

Die Erfindungsaufgabe wird durch das erfindungsgemäße Verfahren zur Erzeugung eines Datenstroms aus Blöcken mit den Merkmalen des ersten unabhängigen Anspruchs, und durch die erfindungsgemäße Vorrichtung zur Erzeugung eines Datenstroms aus Blöcken mit den Merkmalen des dritten unabhängigen Anspruchs,

durch das erfindungsgemäße Verfahren zur Rekonstruktion eines Datenstroms von Datenbits aus aufeinander folgend empfangenen Blöcken von Datensymbolen mit den Merkmalen des zweiten unabhängigen Anspruchs und durch die erfindungsgemäße Vorrichtung zur Rekonstruktion eines Datenstroms von Datenbits aus aufeinander folgend empfangenen Blöcken von Datensymbolen mit den Merkmalen des vierten unabhängigen Anspruchs gelöst. Vorteilhafte technische Weiterbildungen sind in den jeweils abhängigen Ansprüchen beansprucht.

Erfindungsgemäß wird jedem Block jeweils eine gleiche Anzahl von Datenbits zugeführt, wobei die allen Blöcken in Summe zugeführten Datenbits der Summe von Datenbits eines vom äußeren Kodierer erzeugten Kode-Wortes entsprechen. Bei Ausfall eines Blockes während der Übertragung verteilen sich die fehlenden Datenbits des ausgefallenen Blockes nach dem Entschachteln (Deinterleaving) gleichmäßig über das vom äußeren Dekodierer zu dekodierende Kode-Wort und können vom äußeren Dekodierer bei ausreichender Kode-Rate problemlos rekonstruiert werden.

Um aus einer konstanten Anzahl von Datenbits, die jeweils jedem Block zugeführt wird, einen Block mit einer zeitveränderlichen Anzahl von Datensymbolen zu erzeugen, die der zeitveränderlichen Blocklänge des jeweiligen Blockes entspricht, wird für jeden einzelnen Block jeweils eine zeitveränderliche kodierte Modulation eingesetzt.

Die zeitveränderliche kodierte Modulation in jedem Block realisiert hierbei im jeweiligen Block eine zeitveränderliche Informationsrate, die dem Verhältnis der dem jeweiligen Block zugewiesenen Datenbits und der im jeweiligen Block erzeugten zeitveränderlichen Anzahl von auf einem Träger modulierten und kodierten Datensymbolen entspricht.

Eine kodierte Modulation wird durch eine in der inneren Kodierung verwendete Kodierungsform und/oder eine in der Modulation verwendete Modulationsform verwirklicht. Hieraus ergeben sich folgende Ausführungsformen für die kombinierte Verwendung einer Kodierungsform und einer Modulationsform in einer kodierten Modulation im Hinblick auf die Realisierung einer bestimmten Anzahl von auf einem Träger des jeweiligen Blocks modulierten Datensymbolen bei vorgegebener Anzahl von Datenbits:

In einer ersten Ausführungsform einer kodierten Modulation wird in jedem einzelnen Zyklus des Zuweisens von Datenbits an einen Block in jedem Block jeweils eine identische Kodierung durchgeführt, die in jedem Block eine identische Anzahl von kodierten Bits erzeugt. Für die Modulation werden unterschiedliche Modulationsformen zwischen den einzelnen Blöcken verwendet. Innerhalb der einzelnen Blöcke können identische oder unterschiedliche Modulationsformen berücksichtigt werden.

In einer ersten Untervariante der ersten Ausführungsform wird in einem inneren Kodierer ein einziges Kode-Wort in jedem einzelnen Block erzeugt und zur Erzeugung von auf einem Träger modulierten kodierten Datensymbolen eines Blockes jeweils eine bestimmte Anzahl der kodierten Bits des einzigen Kode-Worts verwendet.

In einer zweiten Untervariante der ersten Ausführungsform werden in einem inneren Kodierer mehrere Kode-Worte in jedem einzelnen Block erzeugt und zur Erzeugung von auf einem Träger modulierten kodierten Datensymbolen eines Blockes jeweils ein Kode-Wort oder mehrere Kode-Worte des inneren Kodierers verwendet.

Bei der ersten Ausführungsform lässt sich bei einer konstanten Anzahl von einem Block zugewiesenen Datenbits fast jede mögliche Anzahl von auf einem Träger des Blocks modulierten und kodierten Datensymbolen generieren.

In einer zweiten Ausführungsform einer kodierten Modulation wird in jedem einzelnen Zyklus des Zuweisens von Datenbits an einen Block zwischen jedem Block jeweils eine unterschiedliche Kodierung durchgeführt, die in jedem Block jeweils eine unterschiedliche Anzahl von kodierten Bits erzeugt.

In einer ersten Untervariante der zweiten Ausführungsform werden in jedem Block in einem zugehörigen inneren Kodierer mehrere Kode-Worte erzeugt. Jedes einzelne Kode-Wort wird zur Bildung eines einzigen Datensymbols herangezogen, das auf einen zum Block gehörigen Träger moduliert wird.

In einer zweiten Untervariante der zweiten Ausführungsform wird in einem inneren Kodierer ein einziges Kode-Wort in jedem einzelnen Block erzeugt. In jedem Block wird das jeweilige Kode-Wort in einzelne kodierte Bits geteilt, um daraus ein Datensymbol oder mehrere Datensymbole auf einem zum Block jeweils gehörigen Träger zu modulieren.

In einer dritten Untervariante der zweiten Ausführungsform werden innerhalb jedes einzelnen Block in einem zugehörigen inneren Kodierer jeweils mehrere Kode-Worte mit jeweils einer identischen Kodierungsform erzeugt und zur Erzeugung von auf einem Träger modulierten kodierten Datensymbolen eines Blockes jeweils mehrere für die jeweilige Modulationsform erforderliche Anzahl Kode-Worten des inneren Kodierers verwendet.

In einer dritten Ausführungsform einer kodierten Modulation werden in jedem einzelnen Zyklus des Zuweisens von Datenbits an einen Block innerhalb jedes Blocks jeweils mehrere unterschiedliche Kodierungen durchgeführt, die in jedem Block jeweils eine unterschiedliche Anzahl von kodierten Bits erzeugt.

In einer ersten Untervariante der dritten Ausführungsform werden innerhalb jedes einzelnen Blocks in einem zugehörigen inneren Kodierer mehrere Kode-Worte mit jeweils unterschiedlichen Kodierungsformen erzeugt und zur Erzeugung von auf einem Träger modulierten kodierten Datensymbolen eines Blockes jeweils mehrere vollständige und unterschiedlich kodierte Kode-Worten des inneren Kodierers verwendet.

In einer zweiten Untervariante der dritten Ausführungsform werden innerhalb jedes einzelnen Blocks in einem zugehörigen inneren Kodierer mehrere Kode-Worte mit jeweils unterschiedlichen Kodierungsformen erzeugt und zur Erzeugung von auf einem Träger modulierten kodierten Datensymbolen eines Blockes von mehreren unterschiedlich kodierten Kode-Worten des inneren Kodierers jeweils eine gegenüber der Gesamtanzahl von kodierten Bits reduzierte Menge von kodierten Datenbits verwendet.

Bei der zweiten und dritten Ausführungsform lässt sich bei einer konstanten Anzahl von einem Block zugewiesenen Datenbits jede beliebige Anzahl von auf einem Träger des Blocks modulierten und kodierten Datensymbolen generieren.

Das erfindungsgemäße Verfahren und die erfindungsgemäße Vorrichtung zur Erzeugung eines Datenstroms aus Blöcken mit jeweils einer unterschiedlichen Anzahl von Symbolen und das erfindungsgemäße Verfahren und die erfindungsgemäße Vorrichtung zur Rekonstruktion eines Datenstroms von Datenbits aus aufeinander folgend empfangenen Blöcken von Datensymbolen werden mit Ausführungsformen und Untervarianten im Folgenden anhand der Zeichnung im Detail beispielhaft erläutert. Die Figuren der Zeichnung zeigen:

Fig. 1    ein Blockdiagramm einer Sendestufe für einen Block-Ausfall-Kanal,

Fig. 2    eine Darstellung von Block-Verschachtelungs-Verfahren,

Fig. 3    ein Blockdiagramm einer ersten Ausführungsform einer erfindungsgemäßen Sendestufe für einen Block-Ausfall-Kanal,

Fig. 4    ein Blockdiagramm einer zweiten Ausführungsform einer erfindungsgemäßen Sendestufe für einen Block-Ausfall-Kanal,

Fig. 5    eine beispielhafte schematische Darstellung der Verteilung der zu übertragenden Datenbits auf einzelne Blöcke,

Fig. 6    eine beispielhafte Tabelle mit einer beispielhaften Verteilung der zu übertragenden Datenbits auf einzelne Blöcke,

Fig. 7A    eine beispielhafte Datenstruktur eines Blockes im Fall einer ersten Untervariante einer ersten Ausführungsform für eine kodierte Modulation,

Fig. 7B    eine beispielhafte Datenstruktur eines Blockes im Fall einer zweiten Untervariante der ersten Ausführungsform für eine kodierte Modulation,

Fig. 7C    eine beispielhafte Datenstruktur eines Blockes im Fall einer ersten Untervariante der zweiten Ausführungsform für eine kodierte Modulation,

Fig. 7D    eine beispielhafte Datenstruktur eines Blockes im Fall einer zweiten Untervariante einer zweiten Ausführungsform für eine kodierte Modulation,

Fig. 7E    eine beispielhafte Datenstruktur eines Blockes im Fall einer dritten Untervariante einer zweiten Ausführungsform für eine kodierte Modulation,

Fig. 7F    eine beispielhafte Datenstruktur eines Blockes im Fall einer ersten Untervariante einer dritten Ausführungsform für eine kodierte Modulation,

Fig. 7G    eine beispielhafte Datenstruktur eines Blockes im Fall einer zweiten Untervariante einer dritten Ausführungsform für eine kodierte Modulation,

Fig. 8    ein beispielhaftes Blockdiagramm einer erfindungsgemäßen Empfängerstufe für einen Block-Ausfall-Kanal,

Fig. 9    ein Flussdiagramm eines Ausführungsbeispiels des erfindungsgemäßen Verfahrens zur Erzeugung eines Datenstroms aus Blöcken von jeweils aufeinander folgend zu übertragenden Datensymbolen und

Fig. 10    ein Flussdiagramm eines Ausführungsbeispiels des erfindungsgemäßen Verfahrens zur Rekonstruktion eines Datenstroms von Datenbits aus aufeinander folgend empfangenen Blöcken von Datensymbolen.

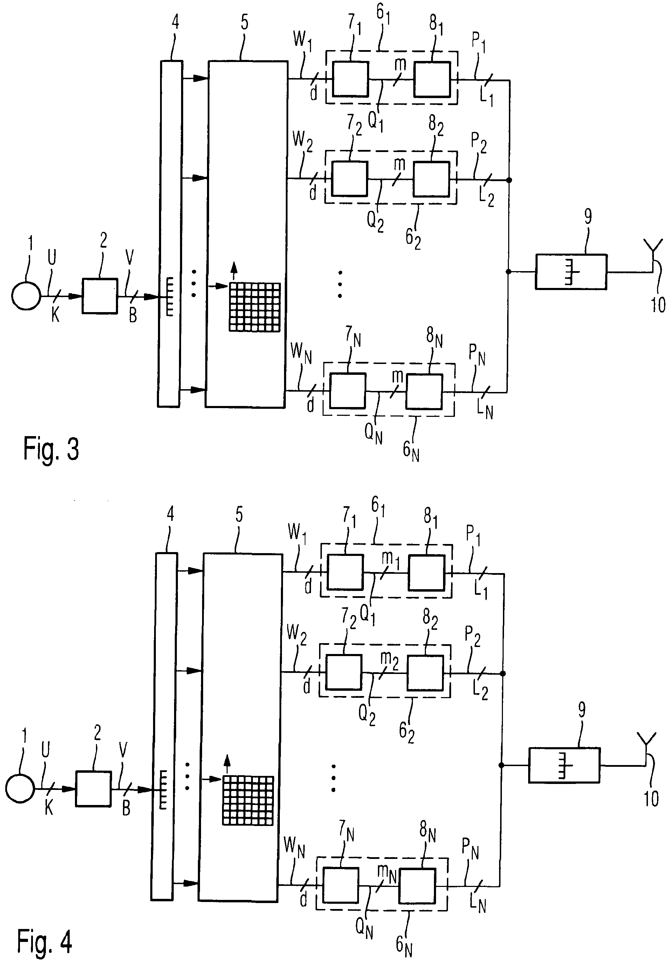

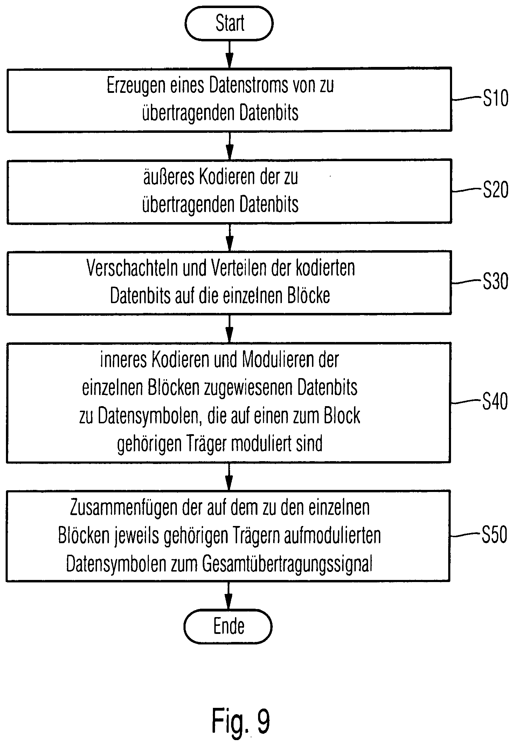

Im Folgenden wird ein Ausführungsbeispiel des erfindungsgemäßen Verfahrens zur Erzeugung eines Datenstroms aus Blöcken von jeweils aufeinander folgend zu übertragenden Datensymbolen anhand des Flussdiagramms in Fig. 9 sowie, ein Ausführungsbeispiel der zugehörigen Vorrichtung zur Erzeugung eines Datenstroms aus Blöcken von jeweils aufeinander folgend zu übertragenden Datensymbolen anhand der Blockdiagramme in den Figuren 3 bzw. 4 erläutert.

Im ersten Verfahrensschritt S10 wird in einer Informationsquelle 1 aus zu übertragenden Informationen ein Datenstrom von Datenbits erzeugt. Hierbei kann es sich um Informationen eines oder mehrerer Nutzer handeln. Die Anwendungsfelder, in denen die auszutauschenden Informationen generiert werden, können sich auf den Austausch von Sprache, Video, Audio und/oder Daten beziehen.

Im nächsten Verfahrensschritt S20 erfolgt eine Kodierung des Datenstroms in einem äußeren Kodierer 2. Hierzu werden jeweils Datenworte bestehend aus jeweils $K$ Bits des unkodierten Datenstroms $U$ zu Kode-Worten bestehend aus jeweils $B$ Bits eines kodierten Datenstroms $V$ ergänzt. Für die äußere Kodierung eignen sich gängige Block-Kodes wie beispielsweise Reed-Solomon-Kodes. Für die Kode-Rate der äußeren Kodierung ist ein geeigneter Wert auszuwählen, der einerseits nicht zu gering zu bemessen ist, um eine sichere Rekonstruktion der Datenbits eines oder mehrerer Blöcke im Fall eines Ausfalls eines oder mehrerer Blöcke während der Übertragung im Rahmen der Dekodierung zu gewährleisten, und andererseits nicht zu hoch auszulegen ist, um eine möglichst hohe Informationsrate in der Übertragung zu erzielen. Der äußere Kodierer 2 bildet mit den noch zu beschreibenden inneren Kodierern $7_1$, $7_2$,..., $7_i$, .., $7_N$ jeweils einen Turbo-Kodierer.

Im darauffolgenden Verfahrensschritt S30 erfolgt in einem Demultiplexer 4 ein Verteilen des kodierten Datenstroms $V$ auf insgesamt $d$ Blöcken mit jeweils $N$ kodierten Datenbits. Die $d$ Blöcke mit jeweils $N$ kodierten Datenbits werden ebenfalls in Verfahrensschritt S30 einem Verschachtler (Interleaver) 5 zugeführt. Beim Verschachtler 5 handelt es sich um einen Blockverschachtler, bei dem gemäß Fig. 2 die $N$ kodierten Datenbits jedes der $d$ Blöcke in jeweils $N$ Speicherelemente von jeweils einer der Zeilen eines internen, matrixförmig angeordneten Speichers geschrieben werden und anschließend die Datenbits der $d$ Speicherelemente von jeder der $N$ Spalten des internen Speichers sequentiell ausgelesen werden und jeweils als Datenstrom $W_1$,$W_2$,..,$W_i$,..,$W_N$ von Blöcken mit jeweils $d$ Datenbits an jeweils einen der $N$ Ausgänge des Verschachtlers 5 geführt werden. Gemäß Fig. 2 kann der Verschachtelungs-Vorgang optional auch ein Vertauschen der Speicherinhalte von Speicherelementen in Spalten und/oder in Zeilen des matrixförmig angeordneten internen Speichers untereinander beinhalten.

Durch das Verschachteln der einzelnen Datenbits der einzelnen Blöcke ist gewährleistet, dass bei Ausfall eines Blockes auf der Übertragungsstrecke die einzelnen Datenbits eines ursprünglichen dem Verschachtler 5 zugeführten Blockes gleichmäßig über alle $N$ durch den Verschachtler 5 generierten Blöcke verteilt sind, nur in Höhe des Faktors $\dfrac{1}{N}$ vom Ausfall betroffen sind und somit im Rahmen der Dekodierung im weiter unten noch zu besprechenden äußeren Dekodierer relativ sicher rekonstruiert werden können.

Im nächsten Verfahrensschritt S40 erfolgt für jeden der insgesamt $N$ Datenströme $W_1$,$W_2$,..,$W_i$,..,$W_N$ aus Blöcken von kodierten Datenbits in jeweils einer Serienschaltung $6_1$,$6_2$,..,$6_i$,..,$6_N$ aus jeweils einem inneren Kodierer $7_1$,$7_2$,..,$7_i$,..,$7_N$ und jeweils einem Modulator $8_1$, $8_2$,..,$8_i$,..,$8_N$ eine kodierte Modulation zu jeweils einem Trägersignal $P_1$,$P_2$,..,$P_i$,..,$P_N$ mit jeweils einer Anzahl $l_1$,$L_2$,..,$L_i$,..,$L_N$ von auf dem Träger modulierten Datensymbolen. Das Trägersignal weist dabei eine blockspezifische Trägerfrequenz auf.

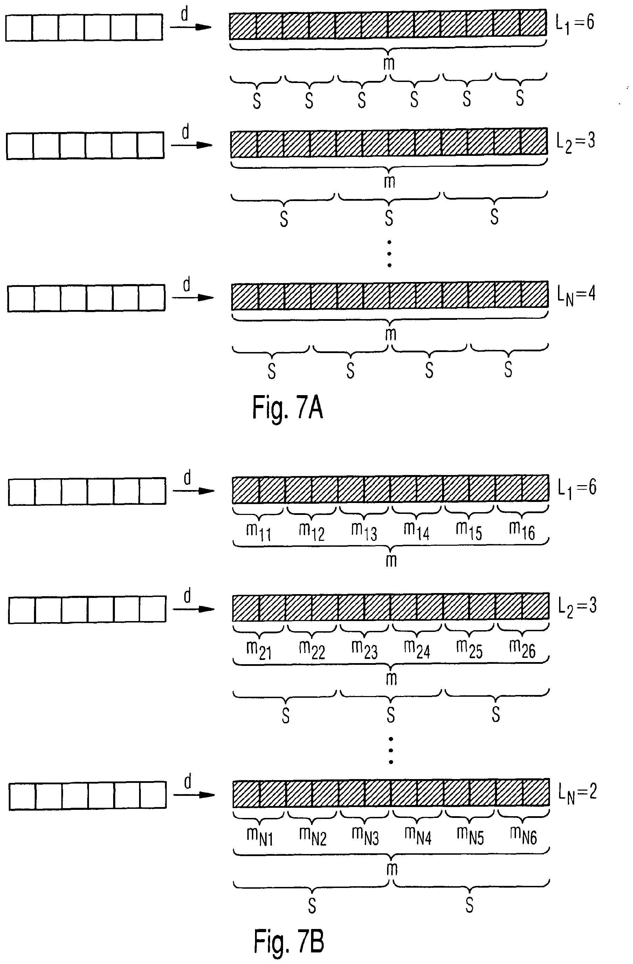

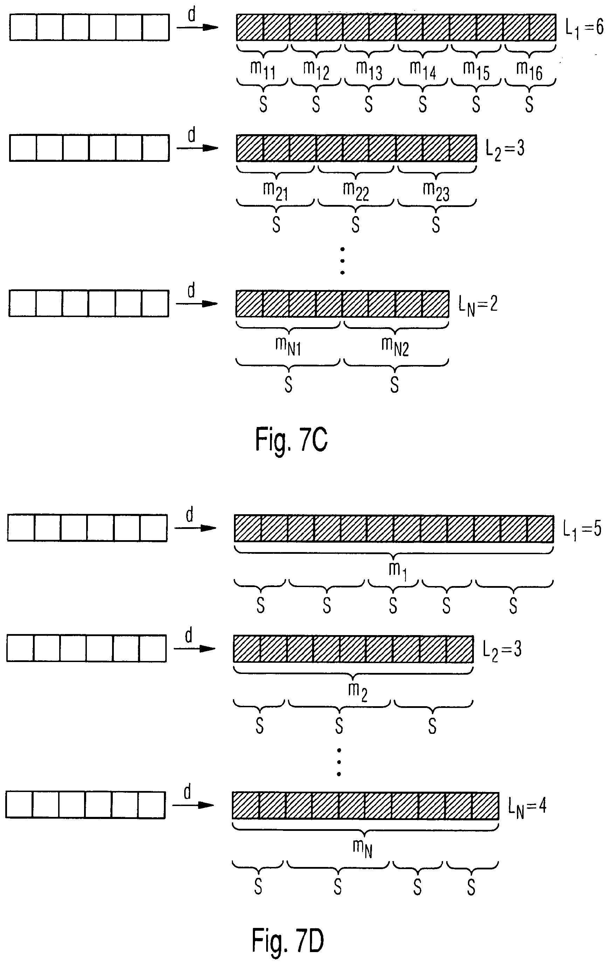

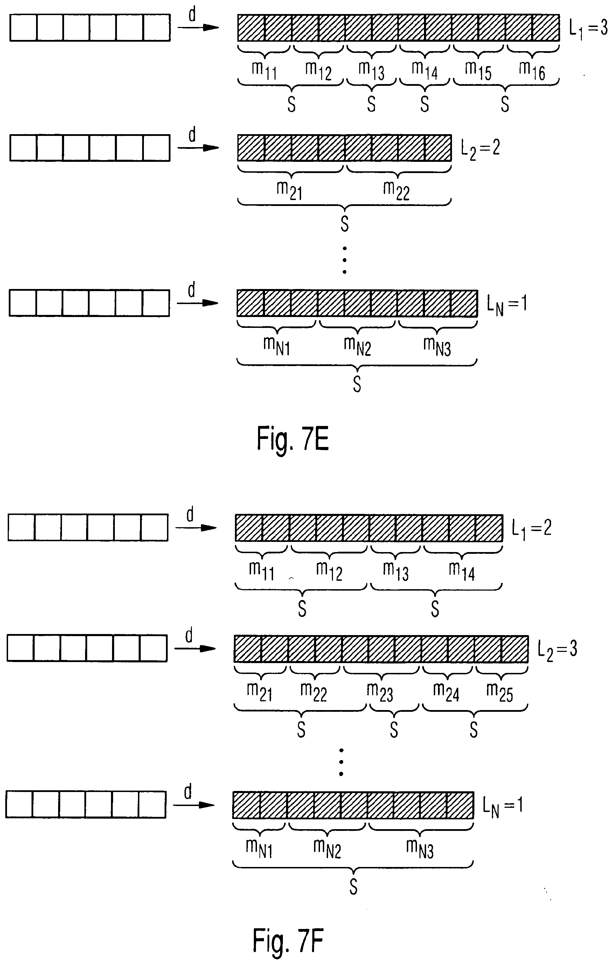

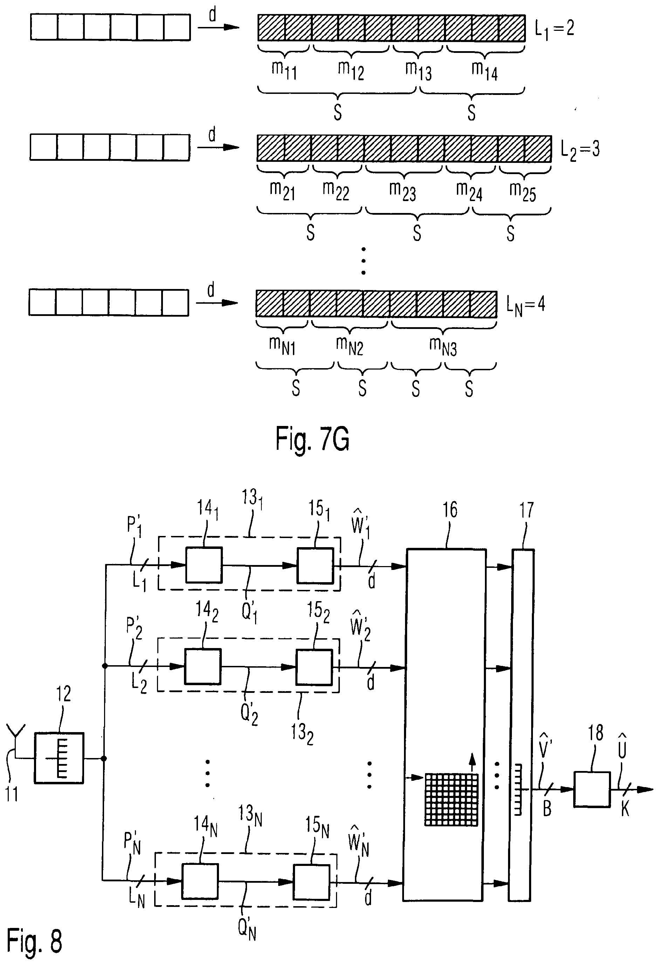

Die Anzahl $L_1$,$L_2$,..,$L_i$,..,$L_N$ von Datensymbolen in jedem einzelnen der insgesamt $N$ Blöcke ist jeweils zeitveränderlich und kann auch zwischen den einzelnen Blöcken unterschiedlich sein. Da die Anzahl $d$ von Datenbits, die jedem einzelnen Block der Datenströme $W_1$,$W_2$,..,$W_i$,..,$W_N$ zugeführt wird, gleich ist, während die Anzahl $L_1$,$L_2$,..,$L_i$,..,$L_N$ von Datensymbolen $S$ in jedem einzelnen Block der insgesamt $N$ Datenströme $W_1$,$W_2$,..,$W_i$,..,$W_N$ jeweils zeitveränderlich ist, ist eine zeitveränderliche kodierte Modulation erforderlich, die durch eine Änderung der Kodierungsform und/oder durch eine Änderung der Modulationsform über der Zeit realisierbar ist. Mögliche Ausführungsformen und Untervarianten, in denen jeweils eine Kodierungsform mit einer Modulationsform zur Realisierung einer bestimmten Anzahl $L_1$,$L_2$,..,$L_i$,..,$L_N$ von Datensymbolen $S$ in jedem einzelnen Block der insgesamt $N$ Datenströme $W_1$,$W_2$,..,$W_i$,..,$W_N$ kombiniert wird, werden im Folgenden anhand der Figuren 7A, 7B, 7C, 7D, 7E, 7F und 7G erläutert:

In einer ersten Ausführungsform einer kodierten Modulation, für die das Blockdiagramm der Sendestufe in Fig. 3 gilt, wird im jeweiligen inneren Kodierer $7_1$,$7_2$,..,$7_i$,..,$7_N$ innerhalb eines Blocks von insgesamt $d$ Datenbits jeweils eine identische Anzahl von Datenbits zur Bildung eines Kode-Worts oder mehrerer Kode-Worte mit einer Anzahl $m$ von kodierten Bits im jeweiligen Datenstrom $Q_1$,$Q_2$,..,$Q_i$,..,$Q_N$ von Kode-Worten herangezogen.

Anschließend werden in dem zum jeweiligen Block gehörigen Modulator $8_1$, $8_2$,..,$8_i$,..,$8_N$ jeweils ein Kode-Wort oder mehrere Kode-Worte in jeweils ein Datensymbol $S$ übergeführt und auf einen Träger moduliert. Die verwendeten Modulationsformen sind zwischen den einzelnen Blöcken jeweils unterschiedlich und können innerhalb eines Blockes entweder identisch oder verschieden sein.

In einer ersten Untervariante einer ersten Ausführungsform einer kodierten Modulation, deren Datenstruktur in Fig. 7A dargestellt ist, wird in jedem Block jeweils ein einzige Kode-Wort mit einer Anzahl $m$ von kodierten Bits erzeugt und werden die einzelne kodierten Bits dieses einzigen Kode-Worts zur Bildung jeweils eines Datensymbols S verwendet, wobei die Anzahl der kodierten Bits von der bei der Modulation jedes Datensymbols S verwendeten Modulationsform abhängt. In Fig. 1A sind beispielhaft die verwendeten Modulationsformen zwischen den einzelnen Blöcken jeweils unterschiedlich, während sie innerhalb der einzelnen Blöcke jeweils identisch sind. Alternativ können die verwendeten Modulationsformen innerhalb der einzelnen Blöcke mittels Verwendung eines zeitveränderlichen Modulators auch unterschiedlich sein.

In einer zweiten Untervariante einer erste Ausführungsform einer kodierten Modulation, deren Datenstruktur in Fig. 7B dargestellt ist, werden in jedem Block jeweils mehrere kodierte Kode-Worte mit einer zugehörigen Anzahl $m_{1j}, m_{2j}, ..., m_{ij}, .., m_{Nj}$ von kodierten Bits erzeugt (der Index $j$ bezieht sich dabei auf das jeweilige Kode-Wort innerhalb eines Blocks). Die Kodierung ist sowohl innerhalb der einzelnen Blöcke wie auch zwischen den einzelnen Blöcken identisch. Hinsichtlich der Modulation werden zwischen den einzelnen Blöcken unterschiedliche Modulationsformen und innerhalb der einzelnen Blöcke identische oder unterschiedliche Modulationsformen verwendet, hierbei kann ein Kode-Wort oder können mehrere Kode-Worte zu einem Datensymbol S zusammengefasst werden. Auch eine Teilmenge von kodierten Bits eines Kode-Worts oder mehrerer Kode-Worte können jeweils zur Bildung eines Datensymbols herangezogen werden. Im ersten Block der in Fig. 7B dargestellten Datenstruktur wird beispielsweise jedes Kode-Wort jeweils in ein zugehöriges Datensymbol S überführt, während im zweiten Block jeweils zwei Kode-Worte zu einem Datensymbol S und im N-ten Block jeweils drei Kode-Worte zu einem Datensymbol S zusammengefasst werden.

In einer zweiten Ausführungsform einer kodierten Modulation wird im jeweiligen inneren Kodierer $7_1, 7_2, .., 7_i, .., 7_N$ innerhalb eines Blocks von insgesamt $d$ Datenbits jeweils gemäß Fig. 4 eine unterschiedliche Anzahl $m_1, m_2, ..., m_i, .., m_N$ von kodierten Bits zur Bildung von einem Kode-Wort oder mehreren Kode-Worten im jeweiligen Datenstrom $Q_1, Q_2, .., Q_i, .., Q_N$ von *Kode-Worten herangezogen.* Die einzelnen Kode-Worte innerhalb eines Blockes weisen jeweils eine Anzahl $m_{1j}, m_{2j}, ..., m_{ij}, .., m_{Nj}$ von kodierten Bits auf.

Anschließend werden in dem zum jeweiligen Block gehörigen Modulator $8_1, 8_2, .., 8_i, .., 8_N$ jeweils ein Kode-Wort oder mehrere Kode-Worte in jeweils ein Datensymbol S übergeführt und auf einen Träger moduliert, wobei die innerhalb der einzelnen Blöcke verwendete Modulationsform identisch oder unterschiedlich und die zwischen den einzelnen Blöcken verwendete Modulationsform unterschiedlich ist.

In einer ersten Untervariante einer zweiten Ausführungsform einer kodierten Modulation, deren Datenstruktur in Fig. 7C dargestellt ist, werden in jedem Block jeweils mehrere kodierte Kode-Worte erzeugt. Die Kodierung ist innerhalb der einzelnen Blöcke identisch, während sie zwischen den einzelnen Blöcken unterschiedlich ist. Somit ergibt sich eine unterschiedliche Anzahl $m_1, m_2, ..., m_i, .., m_N$ von kodierten Bits zwischen den einzelnen Blöcken, während die einzelnen Kode-Worte innerhalb der einzelnen Blöcke jeweils eine Anzahl $m_{1j}, m_{2j}, ..., m_{ij}, .., m_{Nj}$ von kodierten Bits aufweisen. Da jedes einzelne Kode-Wort in ein zugehöriges Datensymbol S überführt wird, werden zwischen den einzelnen Blöcken unterschiedliche Modulationsformen verwendet, während innerhalb der einzelnen Blöcke jeweils eine identische Modulationsform benutzt wird.

In einer zweiten Untervariante einer zweiten Ausführungsform einer kodierten Modulation, deren Datenstruktur in Fig. 7D dargestellt ist, wird in den einzelnen inneren Kodierern $7_1, 7_2, .., 7_i, .., 7_N$ jeweils ein einziges Kode-Wort mit einer zugehörigen Anzahl $m_1, m_2, ..., m_i, .., m_N$ von kodierten Bits erzeugt. Typischerweise werden, wie in Fig. 7D dargestellt sind, innerhalb der einzelnen Blöcke unterschiedliche Modulationsformen verwendet. Um eine unterschiedliche Anzahl $L_1, L_2, ..., L_i, .., L_N$ von Datensymbolen S zwischen den einzelnen Blöcken zu erzeugen, kann alternativ aufgrund der unterschiedlichen Anzahl $m_1, m_2, ..., m_i, .., m_N$ von kodierten Bits in jedem Block auch die Verwendung einer identischen Modulationsform in jedem Block u.U. zielführend sein und ist von der Erfindung mit abgedeckt. Schließlich kann die Verwendung von unterschiedlichen Modulationsformen zwischen den einzelnen Blöcken auch u.U. zielführend sein und ist ebenfalls von der Erfindung mit abgedeckt.

In einer dritten Untervariante einer zweiten Ausführungsform einer kodierten Modulation, deren Datenstruktur in Fig. 7E dargestellt ist, werden in den einzelnen inneren Kodierern $7_1, 7_2, .., 7_i, .., 7_N$ jeweils mehrere Kode-Worte erzeugt, wobei die verwendete Kodierungsform in Äquivalenz zur ersten Untervariante der zweiten Ausführungsform innerhalb der einzelnen Blöcke identisch ist, während sie zwischen den einzelnen Blöcken unterschiedlich ist. Somit ergibt sich eine unterschiedliche Anzahl $m_1, m_2, ..., m_i, .., m_N$ von kodierten Bits zwischen den einzelnen Blöcken, während die einzelnen Kode-Worte innerhalb der einzelnen Blöcke jeweils eine Anzahl $m_{1j}, m_{2j}, ..., m_{ij}, .., m_{Nj}$ von kodierten Bits aufweisen. In der sich anschließenden Modulation werden jeweils mehrere identisch kodierte Kode-Worte in jedem Block in ein Datensymbol S überführt und auf einen zum Block gehörigen Träger moduliert.

Schließlich ist von der Erfindung auch eine vierte Untervariante der zweiten Ausführungsform der kodierten Modulation abgedeckt, die in den Figuren nicht dargestellt ist, bei der eine Teilmenge der kodierten Bits von einem Kode-Wort oder mehreren Kode-Worten zu einem Datensymbol S zusammengefasst werden und auf einem zum Block gehörigen Träger moduliert werden.

In einer dritten Ausführungsform einer kodierten Modulation werden im jeweiligen inneren Kodierer $7_1, 7_2, .., 7_i, .., 7_N$ innerhalb eines Blocks von insgesamt $d$

Datenbits jeweils gemäß Fig. 4 eine unterschiedliche Anzahl $m_1, m_2,..., m_i,.., m_N$ von kodierten Bits zur Bildung von mehreren Kode-Worten im jeweiligen Datenstrom $Q_1, Q_2,.., Q_i,.., Q_N$ von *Kode-Worten herangezogen*. Die einzelnen Kode-Worte innerhalb eines Blockes weisen jeweils eine Anzahl $m_{1j}, m_{2j}..., m_{ij},.., m_{Nj}$ von kodierten Bits auf, wobei die Anzahl $m_{1j}, m_{2j},..., m_{ij},.., m_{Nj}$ von kodierten Bits der einzelnen Kode-Worte innerhalb eines Blockes in Abgrenzung zur zweiten Ausführungsform der kodierten Modulation aufgrund der Verwendung unterschiedlicher Kodierungsformen jeweils unterschiedlich groß ist.

Anschließend werden in dem zum jeweiligen Block gehörigen Modulator $8_1, 8_2, .. , 8_i, .., 8_N$ unter Anwendung einer identischen oder unterschiedlichen Modulationsform innerhalb eines Blockes und einer unterschiedlichen Modulationsform zwischen den einzelnen Blöcken jeweils ein Kode-Wort oder mehrere Kode-Worte in jeweils ein Datensymbol S übergeführt und auf einen Träger moduliert.

In einer ersten Untervariante einer dritten Ausführungsform einer kodierten Modulation, deren Datenstruktur in Fig. 7F dargestellt ist, werden in den zu den einzelnen Blöcken jeweils gehörigen inneren Kodierern $7_1, 7_2,.., 7_i,.., 7_N$ jeweils Kode-Worte mit unterschiedlichen Kodierungsformen innerhalb jedes einzelnen Blocks und gleichzeitig zwischen den einzelnen Blöcken erzeugt. In der sich anschließenden Modulation werden jeweils mehrere unterschiedlich kodierte Kode-Worte in ein Datensymbol S überführt und auf einen zum Block gehörigen Träger moduliert. Die dabei verwendeten Modulationsformen können dabei innerhalb eines Blockes identisch (siehe Modulationsform im ersten Block der in Fig. 7F dargestellten Datenstruktur) oder unterschiedlich sein (siehe Modulationsformen im zweiten Block der in Fig. 7F dargestellten Datenstruktur).

In einer zweiten Untervariante der dritten Ausführungsform einer kodierten Modulation, deren Datenstruktur in Fig. 7G dargestellt ist, werden die Kode-Worte innerhalb jedes einzelnen Blocks und auch zwischen unterschiedlichen Blöcken jeweils mit unterschiedlichen Kodierungsformen erzeugt. In der sich anschließenden Modulation wird jeweils eine Teilmenge von Kodierungsbits von mehreren unterschiedlich kodierten Kode-Worten in ein Datensymbol S überführt und auf einen zum Block gehörigen Träger moduliert.

Im abschließenden Verfahrensschritt S50 werden in einem Multiplexer 9 die in den einzelnen Modulatoren $8_i, 8_2,.., 8_i,.., 8_N$ jeweils erzeugten Trägersignale $P_1, P_2,.., P_i,.., P_N$ mit jeweils einer Anzahl $L_1, L_2,.., L_i,.., L_N$ von auf dem Träger modulierten Datensymbolen S zu einem Gesamtübertragungssignal zusammengefasst und einer Antenne 10 zur Ausstrahlung zugeführt.

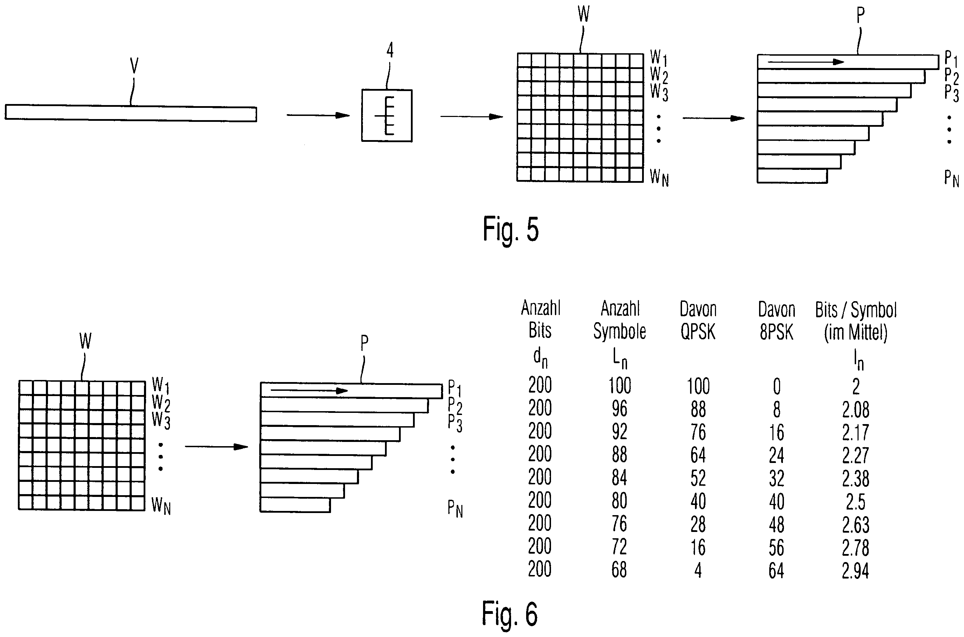

In Fig. 5 ist noch einmal schematisch zusammengefasst, wie ein Datenstrom V von durch den äußeren Kodierer 2 erzeugten Kode-Worten über einen Multiplexer 4 in insgesamt N Datenströme $W_1, W_2,.., W_i,.., W_N$ aufgeteilt wird, die jeweils eine identische Anzahl d von Datenbits aufweisen und durch eine zeitveränderliche kodierte Modulation in Trägersignale $P_1, P_2,.., P_i,.., P_N$ mit jeweils einer zeitveränderlichen Anzahl $L_1, L_2,.., L_i,.., L_N$ von auf dem Träger modulierten Datensymbolen S gewandelt werden.

Darauf aufbauend wird in Fig. 6 beispielhaft aufgezeigt, wie bei insgesamt N Datenströmen $W_1, W_2,.., W_i,.., W_N$ mit Blöcken, die jeweils eine identische Anzahl m = 200 von Datenbits aufweisen, Trägersignale $P_1, P_2,.., P_i,.., P_N$ mit jeweils einer unterschiedlichen Anzahl $L_1, L_2,..., L_i,.., L_N$ von auf einem Träger modulierten Datensymbolen S generiert werden können. Die unterschiedliche Anzahl $L_1, L_2,.., L_i,.., L_N$ von auf einem Träger modulierten Datensymbolen S pro Trägersignal $P_1, P_2,.., P_i,.., P_N$ wird durch eine unterschiedlich zusammengesetzte Anzahl von durch zwei Modulationsformen jeweils auf ein Trägersignal modulierten Datensymbolen (Anzahl der QPSK-modulierten Datensymbole im Verhältnis zur Anzahl der 8PSK-modulierten Datensymbole) realisiert. Auf diese Weise wird für jeden Block in den einzelnen Datenströmen $W_1, W_2,.., W_i,.., W_N$ eine zeitveränderliche Informationsrate $I_1, I_2,.., I_i,.., I_N$ als Verhältnis der identischen Anzahl d von Datenbits pro Block und der zeitveränderlichen Anzahl $L_1, L_2,.., L_i,.., L_N$ von Datensymbolen pro Block

$$( I_1 = \frac{d}{L_1}, I_2 = \frac{d}{L_2}, .., I_i = \frac{d}{L_i}, .., I_N = \frac{d}{L_N} )$$

erzeugt.

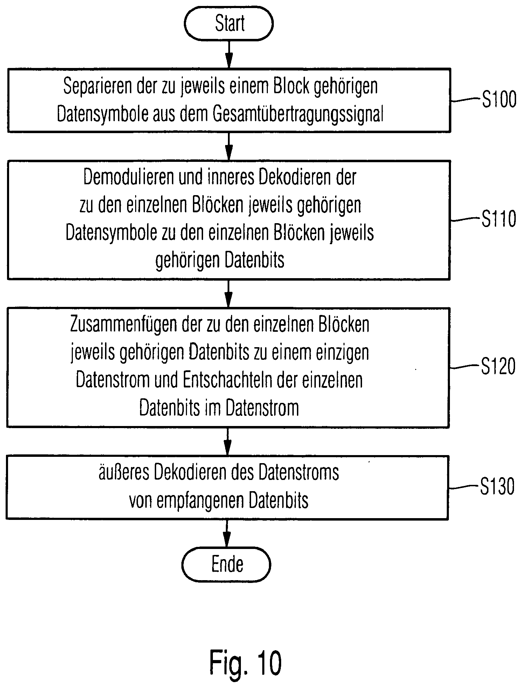

Im Folgenden wird ein Ausführungsbeispiel des erfindungsgemäßen Verfahrens zur Rekonstruktion eines Datenstroms von Datenbits aus aufeinander folgend empfangenen Blöcken von Datensymbolen anhand des Flussdiagramms in Fig. 10 in Kombination mit der erfindungsgemäßen Vorrichtung zur Rekonstruktion eines Datenstroms von Datenbits aus aufeinander folgend empfangenen Blöcken von Datensymbolen anhand des Ausführungsbeispiels des Blockdiagramms in Fig. 8 erläutert.

Im ersten Verfahrensschritt S100 werden die im Gesamtübertragungssignal enthaltenen Trägersignale $P_1', P_2',.., P_i',.., P_N'$, die jeweils eine unterschiedliche Trägerfrequenz aufweisen, nach dem Empfang mit einer Antenne 11 in einem Demultiplexer 12 auf insgesamt N einzelne Trägersignale $P_1', P_2',.., P_i',.., P_N'$ mit jeweils einer Anzahl $L_1, L_2,.., L_i,.., L_N$ von auf dem Träger modulierten Datensymbolen pro Block aufgeteilt. Die für den Empfänger beim Demultiplexen relevante Information, welche zeitveränderliche Anzahl $L_1, L_2,.., L_i,.., L_N$ von auf dem jeweiligen Trägersignal $P_1', P_2',.., P_i',.., P_N'$ modulierten Datensymbolen S pro Block in der zeitlichen Sequenz übertragen wird und damit welche Kodierungs- und Modulationsform beim Kode-Wort bzw. beim einzelnen Datensymbol innerhalb eines Blockes verwendet wird, ist zwischen Sender und Empfänger vorab abgestimmt und wird beispielsweise im Transmission-Security-Layer zwischen Sender und Empfänger übertragen.

Im nächsten Verfahrensschritt S110 erfolgt in einer jeweiligen Serienschaltung $13_1$, $13_2$,..., $13_i$,..,$13_N$ bestehend aus Demodulatoren $14_1$,$14_2$,..,$14_i$,..,$14_N$ und inneren Dekodierern $15_1$,$15_2$,..,$15_i$,..,$15_N$ eine kombinierte Demodulation und innere Dekodierung der in den Blöcken der jeweiligen Trägersignale $P_1'$,$P_2'$,..,$P_i'$,..,$P_N'$ auf einem Träger jeweils modulierten Datensymbole $S$. Während in der Demodulation aus den auf den jeweiligen Trägersignalen $P_1'$,$P_2'$,..,$P_i'$,..,$P_N'$ modulierten Datensymbolen $S$ die zugehörigen Datenströme $Q_1'$,$Q_2'$,..,$Q_i'$,..,$Q_N'$ von Kode-Worten ermittelt werden, werden in der inneren Dekodierung aus den Datenströmen $Q_1'$,$Q_2'$,..,$Q_i'$,..,$Q_N'$ von Kode-Worten Schätzwerte für Datenworte in Blöcken von Datenströmen

$$\hat{W}_1', \hat{W}_2',.., \hat{W}_i',.., \hat{W}_N'$$

erzeugt, die jeweils eine konstante Anzahl $d$ von Datenbits enthalten.

Die Demodulation und innere Dekodierung ist spiegelbildlich zur Modulation und inneren Kodierung realisiert. Insofern gelten die in Verfahrensschritt S40 des erfindungsgemäßen Verfahrens zur Erzeugung eines Datenstroms aus Blöcken von jeweils aufeinander folgend zu übertragenden Datensymbolen genannten Ausführungsformen und Untervarianten der kodierten Modulation spiegelbildlich auch für die kombinierte Demodulation und Dekodierung in Verfahrensschritt S110 und werden deshalb in diesem Zusammenhang nicht mehr explizit und detailliert erläutert.

Im darauffolgenden Verfahrensschritt S120 werden die insgesamt $d$ Datenbits in den einzelnen Blöcken der insgesamt $N$ Datenströme $\hat{W}_1'$,$\hat{W}_2'$,..,$\hat{W}_i'$,..,$\hat{W}_N'$ in einem Entschachtler 16 spiegelbildlich zum Verschachtler 5 in den Figuren 3 und 4 auf insgesamt $d$ Blöcke mit jeweils $N$ Datenbits verteilt. Hierbei können die in Fig. 2 dargestellten Verschachtelungs- bzw. Interleaving-Verfahren spiegelbildlich auf den Entschachtelungs- bzw. Deinterleaving-Vorgang angewendet werden.

Ebenfalls in Verfahrensschritt S120 erfolgt in einem Multiplexer 17 das Zusammenfügen der insgesamt $d$ im Entschachtler 16 erzeugten Blöcke mit jeweils $N$ Datenbits zu einem einzigen Datenstrom $\hat{V}$ mit kodierten Datenworten bestehend aus jeweils $B$ Datenbits.

Schließlich erfolgt im abschließenden Verfahrensschritt S130 die äußere Dekodierung des Datenstroms $\hat{V}$ mit Datenworten bestehend aus jeweils $B$ Datenbits in einem äußeren Dekodierer 18, der Schätzwerte für unkodierte Datenworte eines Datenstroms $\hat{U}$ mit unkodierten Datenworten, bestehend aus jeweils $K$ Datenbits, erzeugt.

Die Erfindung ist nicht auf die dargestellten Ausführungsformen und Untervarianten in den beiden erfindungsgemäßen Verfahren und in den beiden erfindungsgemäßen Vorrichtungen beschränkt. Alle beschriebenen und/oder gezeichneten Merkmale sind im Rahmen der Erfindung beliebig miteinander kombinierbar.

**Patentansprüche**

1. Verfahren zur Erzeugung eines Datenstroms aus Blöcken mit jeweils einer bestimmten Anzahl von zu übertragenden Datensymbolen ($S$) mit folgenden Verfahrensschritten:

   Aufteilen von zu übertragenden Datenbits auf die einzelnen zu erzeugenden Blöcke des Datenstroms in einem Demultiplexer und
   Erzeugen von Datensymbolen ($S$) in den einzelnen Blöcken durch kodierte Modulation der auf die einzelnen Blöcke jeweils aufgeteilten Datenbits, wobei
   jedem Block jeweils eine gleiche Anzahl ($d$) von Datenbits zugewiesen wird,
   **dadurch gekennzeichnet, dass** die Anzahl($L_1$,$L_2$,..,$L_i$,..,$L_N$) von modulierten Datensymbolen($S$) zwischen den einzelnen Blöcken jeweils zeitveränderlich ist und dass aus den dem jeweiligen Block zugewiesenen Datenbits durch eine im jeweiligen Block jeweils verwendete zeitveränderliche kodierte Modulation, die eine zeitveränderliche Informationsrate ($I_1$,$I_2$,..,$I_i$,..,$I_N$) im jeweiligen Block realisiert, die zeitveränderliche Anzahl ($L_1$,$L_2$,..,$L_i$,..,$L_N$) von Datensymbolen ($S$) im jeweiligen Block erzeugt werden,
   wobei die im jeweiligen Block verwendete zeitveränderliche kodierte Modulation durch zeitliche Änderung einer verwendeten Modulationsform erfolgt.

2. Verfahren nach Anspruch 1,
   **dadurch gekennzeichnet,**
   **dass** die im jeweiligen Block verwendete zeitveränderliche kodierte Modulation durch zeitliche Änderung einer in einer inneren Kodierung verwendeten Kodierungsform erfolgt.

3. Verfahren nach einem der Ansprüche 1 oder 2,
   **dadurch gekennzeichnet,**
   **dass** im jedem Block jeweils eine identische Kodierungsform verwendet wird und zwischen den Blöcken unterschiedliche Modulationsformen verwendet werden.

4. Verfahren nach Anspruch 3,
   **dadurch gekennzeichnet,**
   **dass** innerhalb eines Blockes identische Modulationsformen verwendet werden.

5. Verfahren nach Anspruch 3,
   **dadurch gekennzeichnet,**

**dass** innerhalb eines Blockes verschiedene Modulationsformen verwendet werden.

6. Verfahren nach einem der Ansprüche 1 oder 2, **dadurch gekennzeichnet,** **dass** zwischen den einzelnen Blöcken jeweils unterschiedliche Kodierungsformen verwendet werden.

7. Verfahren nach Anspruch 6, **dadurch gekennzeichnet,** **dass** ein einziges Kode-Wort in ein zugehöriges Datensymbol ($S$) zur Modulation auf einen zum jeweiligen Block gehörigen Träger gepackt wird.

8. Verfahren nach Anspruch 6, **dadurch gekennzeichnet,** **dass** mehrere Kode-Worte in ein zugehöriges einziges Datensymbol ($S$) zur Modulation auf einen zum jeweiligen Block gehörigen Träger gepackt werden.

9. Verfahren nach Anspruch 6, **dadurch gekennzeichnet,** **dass** ein Teil von kodierten Bits eines Kode-Worts jeweils in ein zugehöriges Datensymbol ($S$) zur Modulation auf einen zum jeweiligen Block gehörigen Träger gepackt wird.

10. Verfahren nach einem der Ansprüche 1 oder 2, **dadurch gekennzeichnet,** **dass** innerhalb der einzelnen Blöcke jeweils mehrere Kodierungsformen verwendet werden.

11. Verfahren nach einem der Ansprüche 1 bis 10, **dadurch gekennzeichnet,** **dass** die zu übertragenden Datenbits vor der Zuweisung zu den einzelnen Blöcken einer äußeren Kodierung unterworfen werden.

12. Verfahren nach Anspruch 11, **dadurch gekennzeichnet,** **dass** die Anzahl ($N$) von Blöcken fix ist und einem Quotient aus der Anzahl ($B$) von in einem durch die äußere Kodierung erzeugten Kode-Wort enthalten Datenbits und der Anzahl ($d$) der in einem Block jeweils enthalten Datenbits entspricht.

13. Verfahren nach einem der Ansprüche 1 bis 12, **dadurch gekennzeichnet,** **dass** die zu übertragenden Datenbits vor der Zuweisung zu den einzelnen Blöcken untereinander verschachtelt werden.

14. Verfahren nach einem der Ansprüche 1 bis 13, **dadurch gekennzeichnet,** **dass** die einzelnen Blöcke von jeweils aufeinander folgend zu übertragenden Datensymbolen ($S$) sequentiell zum Datenstrom zusammengefasst werden.

den.

15. Verfahren zur Rekonstruktion eines Datenstroms von Datenbits aus aufeinander folgend empfangenen Blöcken mit jeweils einer bestimmten Anzahl von Datensymbolen ($S$) mit folgenden Verfahrensschritten:

Separieren der zu jeweils einem Block gehörigen Datensymbole ($S$),
Rekonstruieren der in den Datensymbolen ($S$) der einzelnen Blöcke jeweils enthaltenen Datenbits durch kombinierte Demodulation und Dekodierung und
Zusammensetzen des Datenstroms von Datenbits mit den aus den Datensymbolen ($S$) der einzelnen Blöcke jeweils rekonstruierten Datenbits,
wobei jedem Block jeweils eine gleiche Anzahl ($d$) von Datenbits zugewiesen ist,
**dadurch gekennzeichnet, dass** die in jeweils einem Block übertragene Anzahl ($L_1$, $L_2$,.., $L_i$, ..,$L_N$) von Datensymbolen($S$) zwischen den einzelnen Blöcken jeweils zeitveränderlich ist und
dass aus den dem jeweiligen Block zugewiesenen Datenbits durch eine im jeweiligen Block jeweils verwendete zeitveränderliche kodierte Modulation, die eine zeitveränderliche Informationsrate ($I_1'$,$I_2$,..,$I_i$,..,$I_N$) im jeweiligen Block realisiert, die zeitveränderliche Anzahl ($L_1$,$L_2$,..,$L_i$..,$L_N$) von Datensymbolen ($S$) im jeweiligen Block erzeugt sind,
wobei die im jeweiligen Block verwendete zeitveränderliche kodierte Modulation durch zeitliche Änderung einer verwendeten Modulationsform erfolgt ist.

16. Vorrichtung zur Erzeugung eines Datenstroms aus Blöcken mit jeweils einer bestimmten Anzahl von zu übertragenden Datensymbolen ($S$) mit
einem Demultiplexer (4) zum Aufteilen von zu übertragenden Datenbits auf in den einzelnen zu erzeugenden Blöcken des Datenstroms jeweils zu übertragenden Datenbits und
jeweils einer Serienschaltung ($6_1$,$6_2$,..,$6_i$,..,$6_N$) aus einem inneren Kodierer ($7_1$,$7_2$,..,$7_i$,..,$7_N$) und einem zeitveränderlichen Modulator ($8_1$,$8_2$,..,$8_i$,..,$8_N$) für jeden Block zum Erzeugen von Datensymbolen ($S$) im jeweiligen Block aus den auf den jeweiligen Block jeweils aufgeteilten Datenbits, wobei der Demultiplexer (4) jedem Block jeweils eine gleiche Anzahl ($d$) von Datenbits zuweist,
**dadurch gekennzeichnet, dass** die Anzahl($L_1$,$L_2$,..,$L_i$,..,$L_N$)von modulierten Datensymbolen(S) zwischen den einzelnen Blöcken jeweils zeitveränderlich ist und
dass die zeitveränderlichen Modulatoren ($8_1$,

$8_2,..,8_i,..,8_N$) aus den dem jeweiligen Block zugewiesenen Datenbits durch eine im jeweiligen Block jeweils verwendete zeitveränderliche kodierte Modulation, die eine zeitveränderliche Informationsrate ($I_1',I_2,..,I_i,..,I_N$) im jeweiligen Block realisiert, die zeitveränderliche Anzahl ($L_1,L_2,..,L_i,..,L_N$) von Datensymbolen ($S$) im jeweiligen Block erzeugen, wobei die im jeweiligen Block verwendete zeitveränderliche kodierte Modulation durch zeitliche Änderung einer verwendeten Modulationsform erfolgt.

**17.** Vorrichtung nach Anspruch 16,
**dadurch gekennzeichnet,**
**dass** dem Demultiplexer (4) ein äußerer Kodierer (2) zur Erzeugung eines Kode-Wortes aus zu übertragenden Datenbits vorgeschaltet ist, wobei die in einem Kode-Wort jeweils enthaltene Anzahl ($B$) von Datenbits dem Produkt aus der fixen Anzahl ($N$) von Blöcken und der jedem Block jeweils zugewiesenen Anzahl ($d$) von Datenbits entspricht.

**18.** Vorrichtung nach Anspruch 16 oder 17,
**dadurch gekennzeichnet,**
**dass** dem Demultiplexer (4) ein Verschachtler (5) zum Verschachteln der in einem vom äußeren Kodierer (2) erzeugten Kode-Wort enthaltenen Datenbits unter einander nachgeschaltet ist.

**19.** Vorrichtung nach einem der Ansprüche 16 bis 18,
**dadurch gekennzeichnet,**
**dass** den aus jeweils einem inneren Kodierer ($7_1$, $7_2,.., 7_i,.., 7_N$) und jeweils einem zeitveränderlichen Modulator ($8_1,8_2,...,8_i,..,8_N$) zusammengesetzten Serienschaltungen ($6_1, 6_2,..,6_i,..,6_N$) ein Multiplexer (9) zur Erzeugung des Datenstroms aus den einzelnen Blöcken nachgeschaltet ist.

**20.** Vorrichtung zur Rekonstruktion eines Datenstroms von Datenbits aus aufeinander folgend empfangenen Blöcken mit jeweils einer bestimmten Anzahl von Datensymbolen ($S$) mit einem Demultiplexer (12) zum Separieren der zu jeweils einem Block gehörigen Datensymbole ($S$), wobei jeweils einer Serienschaltung ($13_1,13_2,...,13_i,..,13_N$) aus einem Demodulator ($14_1,14_2,..,14_i,..,14_N$) und einem inneren Dekodierer ($15_1,15_2,..,15_i,..,15_N$) für jeden Block zur Rekonstruktion der in den Datensymbolen ($S$) des jeweiligen Blocks enthaltenen Datenbits und einem Multiplexer (17) zum Zusammensetzen des Datenstroms von Datenbits mit den aus den Datensymbolen ($S$) der einzelnen Blöcke rekonstruierten Datenbits, wobei jedem Block jeweils eine gleiche Anzahl ($d$) von Datenbits zugewiesen ist, **dadurch gekennzeichnet, dass** die in jeweils einem Block übertragene Anzahl($L_1,L_2,..,L_i,..,L_N$) von Datensymbolen($S$) zwischen den einzelnen Blöcken jeweils zeitveränderlich ist und dass aus den dem jeweiligen Block zugewiesenen Datenbits durch eine im jeweiligen Block jeweils verwendete zeitveränderliche kodierte Modulation, die eine zeitveränderliche Informationsrate ($I_1',I_2,..,I_i,..,I_N$) im jeweiligen Block realisiert, die zeitveränderliche Anzahl ($L_1,L_2,..,L_i,..,L_N$) von Datensymbolen ($S$) im jeweiligen Block erzeugt sind, wobei die im jeweiligen Block verwendete zeitveränderliche kodierte Modulation durch zeitliche Änderung einer verwendeten Modulationsform erfolgt ist.

**Claims**

**1.** Method for generating a data stream using blocks, each with a specific number of data symbols ($S$) to be transmitted, with the following method steps:

> dividing data bits to be transmitted among the individual blocks of the data stream which are to be generated, and
> generating data symbols ($S$) in the individual blocks through coded modulation of the data bits divided in each case among the individual blocks, wherein an equal number ($d$) of data bits are assigned in each case to each block,

**characterised in that**
the number ($L_1$, $L_2$,....,$L_i$,...,$L_N$) of modulated data symbols ($S$) are in each case time-varying between the individual blocks, and

> the time-varying number ($L_1$, $L_2$,....,$L_i$,...,$L_N$) of data symbols ($S$) are generated in the respective block from the data bits assigned to the respective block by means of a time-varying coded modulation which is used in each case in the respective block and which implements a time-varying information rate ($I_1$, $I_2$, ...,$I_i$, ...,$I_N$) in the respective block,
> wherein the time-varying coded modulation used in the respective block is effected through temporal modification of a modulation form which is used.

**2.** Method according to claim 1,
**characterised in that**
the time-varying coded modulation used in the respective block is affected through temporal modification of a coding form which is used in an internal coding.

**3.** Method according to one of claims 1 or 2,
**characterised in that**
an identical coding form is used in each case in each block and different modulation forms are used between the blocks.

**4.** Method according to claim 3,
**characterised in that**
identical modulation forms are used within a block.

**5.** Method according to claim 3,
**characterised in that**
different modulation forms are used within a block.

**6.** Method according to one of claims 1 or 2,
**characterised in that**
different coding forms are used in each case between the individual blocks.

**7.** Method according to claim 6,
**characterised in that**
a single code word is packed into an associated data symbol ($S$) for modulation onto a carrier associated with the respective block.

**8.** Method according to claim 6,
**characterised in that**
a plurality of code words are packed into an associated single data symbol ($S$) for modulation onto a carrier associated with the respective block.

**9.** Method according to claim 6,
**characterised in that**
a part of coded bits of a code word are packed in each case into an associated data symbol ($S$) for modulation onto a carrier associated with the respective block.

**10.** Method according to one of claims 1 or 2,
**characterised in that**
a plurality of coding forms are used in each case within the individual blocks.

**11.** Method according to one of claims 1 to 10,
**characterised in that**
the data bits to be transmitted are subjected to an external coding before being assigned to the individual blocks.

**12.** Method according to claim 11,
**characterised in that**
the number ($N$) of blocks is fixed and corresponds to a quotient of the number ($B$) of data bits contained in a code word generated by the external coding and the number ($d$) of data bits contained in each case in a block.

**13.** Method according to one of claims 1 to 12,
**characterised in that**
the data bits to be transmitted are interleaved with one another before being assigned to the individual blocks.

**14.** Method according to one of claims 1 to 13,
**characterised in that**
the individual blocks of data symbols ($S$) to be transmitted in each case consecutively are sequentially combined into the data stream.

**15.** Method for reconstructing a data stream of data bits from consecutively received blocks, each having a specific number of data symbols ($S$), with the following method steps:

separating the data symbols ($S$) associated in each case with a block,
reconstructing the data bits contained in each case in the data symbols ($S$) through combined demodulation and decoding, and
assembling the data stream of data bits with the data bits reconstructed in each case from the data symbols ($S$) of the individual blocks,
wherein an equal number ($d$) of data bits are assigned in each case to each block,

**characterised in that**
the number ($L_1, L_2,...,L_i,...,L_N$) of data symbols ($S$) transmitted in each case in a block are in each case time-varying between the individual blocks, and

the time-varying number ($L_1, L_2,...,L_i,...,L_N$) of data symbols ($S$) are generated in the respective block from the data bits assigned to the respective block by means of a time-varying coded modulation which is used in each case in the respective block and which implements a time-varying information rate ($I_1, I_2, ...,I_i, ...,I_N$) in the respective block,
wherein the time-varying coded modulation used in the respective block is effected through temporal modification of a modulation form which is used.

**16.** Device for generating a data stream using blocks, each with a specific number of data symbols ($S$) to be transmitted, having
a demultiplexer (4) for dividing data bits to be transmitted among data bits to be transmitted in each case in the individual blocks of the data stream which are to be generated, and
in each case a series connection ($6_1, 6_2, ...,6_i, ...,6_N$) of an internal coder ($7_1, 7_2, ...,7_i, ...,7_N$) and a time-varying modulator ($8_1, 8_2, ...,8_i, ...,8_N$) for each block for generating data symbols ($S$) in the respective block from the data bits divided in each case among the respective block,
wherein the demultiplexer (4) assigns an equal number ($d$) of data bits in each case to each block,
**characterised in that**
the number ($L_1, L_2,...,L_i,...,L_N$) of modulated data symbols ($S$) is in each case time-varying between the individual blocks, and

the time-varying modulators $(8_1, 8_2, ...,8_i, ...,8_N)$ generate the time-varying number $(L_1, L_2, ...,L_i, ...,L_N)$ of data symbols $(S)$ in the respective block from the data bits assigned to the respective block by means of a time-varying coded modulation which is used in each case in the respective block and which implements a time-varying information rate $(I_1, I_2, ...,I_i, ...,I_N)$ in the respective block, wherein the time-varying coded modulation used in the respective block is effected through temporal modification of a modulation form which is used.

**17.** Device according to claim 16,
**characterised in that**
an external coder (2) is connected upstream of the demultiplexer (4) to generate a code word from data bits to be transmitted,
wherein the number $(B)$ of data bits contained in each case in a code word corresponds to the product of the fixed number $(N)$ of blocks and the number $(d)$ of data bits allocated in each case to each block.

**18.** Device according to claim 16 or 17,
**characterised in that**
an interleaver (5) is connected downstream of the demultiplexer (4) to interleave the data bits contained in a code word generated by the external coder (2) with one another.

**19.** Device according to one of claims 16 to 18,
**characterised in that**
a multiplexer (9) is connected downstream of the series connections $(6_1, 6_2, ...,6_i, ...,6_N)$ made up in each case of an internal coder $(7_1, 7_2, ...,7_i, ...,7_N)$ and in each case a time-varying modulator $(8_1, 8_2, ...,8_i, ...,8_N)$ in order to generate the data stream from the individual blocks.

**20.** Device for reconstructing a data stream of data bits from consecutively received blocks, each with a specific number of data symbols $(S)$, having
a demultiplexer (12) to separate the data symbols $(S)$ associated in each case with a block,
wherein in each case a series connection $(13_1, 13_2, ...,13_i, ...,13_N)$ of a demodulator $(14_i, 14_2, ...,14_i, ...,14_N)$ and an internal decoder $(15_1, 15_2, ...,15_i, ...,15_N)$ for each block to reconstruct the data bits contained in the data symbols $(S)$ of the respective block, and
a multiplexer (17) to assemble the data stream of data bits with the data bits reconstructed from the data symbols $(S)$ of the individual blocks, wherein an identical number (d) of data bits is assigned in each case to each block,
**characterised in that**
the number $(L_1, L_2, ...,L_i, ...,L_N)$ of data symbols $(S)$ transmitted in each case in a block is in each case time-varying between the individual blocks, and

the number $(L_1, L_2, ...,L_i, ...,L_N)$ of data symbols $(S)$ are generated in the respective block from the data bits assigned to the respective block by means of a time-varying coded modulation which is used in each case in the respective block and which implements a time-varying information rate $(I_1, I_2, ...,I_i, ...,I_N)$ in the respective block,
wherein the time-varying coded modulation used in the respective block is effected through temporal modification of a modulation form which is used.

## Revendications

**1.** Procédé de création d'un flux de données à partir de blocs avec respectivement un nombre déterminé de symboles de données (5) à transmettre avec les étapes de procédé suivantes :

répartition de bits de données à transmettre sur les blocs individuels à créer du flux de données dans un démultiplexeur et
création de symboles de données (5) dans les blocs individuels par modulation codée des bits de données respectivement répartis sur les blocs individuels, dans lequel à chaque bloc est respectivement attribué un même nombre (d) de bits de données,
**caractérisé en ce que**
le nombre $(L_1, L_2, ..., L_i, ..., L_N)$ de symboles de données (S) modulés est respectivement variable dans le temps entre les blocs individuels, et à partir des bits de données attribués au bloc respectif par une modulation codée variable dans le temps respectivement utilisée dans le bloc respectif, laquelle réalise dans le bloc respectif une cadence d'informations $(I_1, I_2, ..., I_i, ..., I_N)$ variable dans le temps, le nombre $(L_1, L_2, ..., L_i, ..., L_N)$ variable dans le temps de symboles de données (5) est créé dans le bloc respectif,
dans lequel la modulation codée variable dans le temps utilisée dans le bloc respectif se produit par variation dans le temps d'une forme de modulation utilisée.

**2.** Procédé selon la revendication 1,
**caractérisé en ce que**
la modulation codée variable dans le temps utilisée dans le bloc respectif se produit par variation dans le temps d'une forme de codage utilisée dans un codage interne.

**3.** Procédé selon l'une des revendications 1 ou 2,
**caractérisé en ce que**
dans chaque bloc est respectivement utilisée une forme de codage identique et entre les blocs sont utilisées des formes de modulation différentes.

**4.** Procédé selon la revendication 3, **caractérisé en ce que** à l'intérieur d'un bloc sont utilisées des formes de modulation identiques.

**5.** Procédé selon la revendication 3, **caractérisé en ce que** à l'intérieur d'un bloc sont utilisées des formes de modulation différentes.

**6.** Procédé selon l'une des revendications 1 ou 2, **caractérisé en ce que** entre les blocs individuels sont respectivement utilisées des formes de codage différentes.

**7.** Procédé selon la revendication 6, **caractérisé en ce que** un unique mot de code dans un symbole de données (5) associé est compacté en vue d'une modulation vers un support appartenant au bloc respectif.

**8.** Procédé selon la revendication 6, **caractérisé en ce que** plusieurs mots de code dans un symbole de données (5) unique associé sont compactés en vue d'une modulation vers un support appartenant au bloc respectif.

**9.** Procédé selon la revendication 6, **caractérisé en ce que** une partie de bits codés d'un mot de code respectivement dans un symbole de données (5) associé est compacté en vue d'une modulation vers un support appartenant au bloc respectif.

**10.** Procédé selon l'une des revendications 1 ou 2, **caractérisé en ce que** à l'intérieur des blocs individuels sont respectivement utilisées plusieurs formes de codage.

**11.** Procédé selon l'une des revendications 1 à 10, **caractérisé en ce que** les bits de données à transmettre sont soumis à un codage externe avant l'attribution vers les blocs individuels.

**12.** Procédé selon la revendication 11, **caractérisé en ce que** le nombre ($N$) de blocs est fixe et correspond à un quotient du nombre ($B$) de bits de données contenus dans un mot de code créé par le codage externe et du nombre ($d$) des bits de données respectivement contenus dans un bloc.

**13.** Procédé selon l'un des revendications 1 à 12, **caractérisé en ce que** les bits de données à transmettre sont reliés entre eux avant l'attribution aux blocs individuels.

**14.** Procédé selon l'une des revendications 1 à 13, **caractérisé en ce que** les blocs individuels de symboles de données (5) à transmettre se suivant respectivement sont regroupés séquentiellement au flux de données.

**15.** Procédé de reconstruction d'un flux de données de bits de données à partir de blocs reçus se suivant avec respectivement un nombre déterminé de symboles de données (5) avec les étapes de procédé suivantes :

séparation des symboles de données (5) appartenant respectivement à un bloc,
reconstruction des bits de données respectivement contenus dans les symboles de données (5) des blocs individuels par démodulation et décodage combinés et
assemblage du flux de données de bits de données avec les bits de données respectivement reconstruits à partir des symboles de données ($S$) des blocs individuels,
dans lequel à chaque bloc est respectivement attribué un même nombre ($d$) de bits de données,
**caractérisé en ce que**
le nombre ($L_1$, $L_2$, ..., $L_i$, ..., $L_N$) de symboles de données (S) transmis dans un bloc respectif est respectivement variable dans le temps entre les blocs individuels, et
à partir des bits de données attribués au bloc respectif par une modulation codée variable dans le temps respectivement utilisée dans le bloc respectif, laquelle réalise dans le bloc respectif une cadence d'informations ($I_1$, $I_2$, ..., $I_i$, ..., $I_N$) variable dans le temps, le nombre ($L_1$, $L_2$, ..., $L_i$, ..., $L_N$) variable dans le temps de symboles de données (5) sont créés dans le bloc respectif, dans lequel la modulation codée variable dans le temps utilisée dans le bloc respectif se produit par variation dans le temps d'une forme de modulation utilisée.

**16.** Dispositif de création d'un flux de données à partir de blocs avec respectivement un nombre déterminé de symboles de données (5) à transmettre avec un démultiplexeur (4) pour répartir des bits de données sur des bits de données à respectivement transmettre dans les blocs individuels à créer du flux de données et
respectivement un montage en série ($6_1$, $6_2$, ..., $6_i$, ..., $6_N$) d'un encodeur interne ($7_1$, $7_2$, ..., $7_i$, ..., $7_N$) et d'un modulateur ($8_1$, $8_2$, ..., $8_i$, ..., $8_N$) pour chaque bloc pour créer des symboles de données (5) dans le bloc respectif à partir des bits de données respectivement répartis sur le bloc respectif, dans lequel le démultiplexeur (4) attribue respectivement à chaque bloc un même nombre ($d$) de bits de données,

**caractérisé en ce que**

le nombre ($L_1$, $L_2$, ..., $L_i$, ..., $L_N$) de symboles de données ($S$) modulés entre les blocs individuels est variable dans le temps respectivement, et

les modulateurs ($8_1$, $8_2$, ..., $8_i$, ..., $8_N$) variables dans le temps créent dans le bloc respectif à partir des bits de données attribués au bloc respectif par une modulation codée variable dans le temps respectivement utilisée dans le bloc respectif, laquelle réalise dans le bloc respectif une cadence d'informations ($I_1$, $I_2$, ..., $I_i$, ..., $I_N$) variable dans le temps, le nombre ($L_1$, $L_2$, ..., $L_i$, ..., $L_N$) variable dans le temps de symboles de données (5),

dans lequel la modulation codée variable dans le temps utilisée dans le bloc respectif se produit par variation dans le temps d'une forme de modulation utilisée.

17. Dispositif selon la revendication 16,
**caractérisé en ce que**
avant le démultiplexeur (4) est monté un encodeur externe (2) pour créer un mot de code à partir de bits de données transmises, dans lequel le nombre ($B$) de bits de données respectivement contenu dans un mot de code correspond au produit du nombre ($N$) fixe de blocs et du nombre ($d$) de bits de données respectivement attribué à chaque bloc.

18. Dispositif selon la revendication 16 ou 17,
**caractérisé en ce que**
après le démultiplexeur (4) est monté un entrelaceur (5) pour entrelacer entre eux les bits de données contenus dans un mot de code créés par l'encodeur externe (2).

19. Dispositif selon l'une des revendications 16 à 18,
**caractérisé en ce que**
après les montages en série assemblés ($6_1$, $6_2$, ..., $6_i$, ..., $6_N$) de respectivement un encodeur interne ($7_1$, $7_2$, ..., $7_i$ ..., $7_N$) et respectivement un modulateur ($8_1$, $8_2$, ..., $8_i$, ..., $8_N$) variable dans le temps, un multiplexeur (9) est monté pour créer le flux de données à partir des blocs individuels.

20. Dispositif de reconstruction d'un flux de données de bits de données à partir de blocs reçus se suivant avec respectivement un nombre déterminé de symboles de données ($S$) avec
un démultiplexeur (12) pour séparer les symboles de données ($S$) appartenant respectivement à un bloc, dans lequel
respectivement un montage en série ($13_1$, $13_2$, ..., $13_i$, ..., $13_N$) constitué d'un démodulateur ($14_1$, $14_2$, ..., $14_i$, ..., $14_N$) et d'un encodeur interne ($15_1$, $15_2$, ..., $15_i$, ..., $15_N$) pour chaque bloc la reconstruction des bits de données contenus dans les symboles de données ($S$) du bloc respectif et
un multiplexeur (17) pour assembler le flux de données de bits de données avec les bits de données reconstruits à partir des symboles de données ($S$) des blocs individuels,

dans lequel à chaque bloc est respectivement attribué un même nombre ($d$) de bits de données,
**caractérisé en ce que**
le nombre ($L_1$, $L_2$, ..., $L_i$, ..., $L_N$) de symboles de données ($S$) transmis dans un bloc respectif est respectivement variable dans le temps entre les blocs individuels, et

à partir des bits de données attribués au bloc respectif par une modulation codée variable dans le temps respectivement utilisée dans le bloc respectif, laquelle réalise dans le bloc respectif une cadence d'informations ($I_1$, $I_2$, ..., $I_i$, ..., $I_N$) variable dans le temps, le nombre ($L_1$, $L_2$, ..., $L_i$, ..., $L_N$) variable dans le temps de symboles de données ($S$) est créé dans le bloc respectif,

dans lequel la modulation codée variable dans le temps utilisée dans le bloc respectif se produit par variation dans le temps d'une forme de modulation utilisée.

Fig. 1

Fig. 2

| N x d | | N x d | | N x d | | N x d |
|---|---|---|---|---|---|---|
| Spaltenweises Hineinschreiben | & (optional) | Permutation der einzelnen Zeilen | & (optional) | Permutation der einzelnen Spalten | & | Zeilenweises Auslesen |

Fig. 3

Fig. 4

16

Fig. 5

| Anzahl Bits $d_n$ | Anzahl Symbole $L_n$ | Davon QPSK | Davon 8PSK | Bits / Symbol (im Mittel) $l_n$ |
|---|---|---|---|---|
| 200 | 100 | 100 | 0 | 2 |
| 200 | 96 | 88 | 8 | 2.08 |
| 200 | 92 | 76 | 16 | 2.17 |
| 200 | 88 | 64 | 24 | 2.27 |
| 200 | 84 | 52 | 32 | 2.38 |
| 200 | 80 | 40 | 40 | 2.5 |
| 200 | 76 | 28 | 48 | 2.63 |
| 200 | 72 | 16 | 56 | 2.78 |
| 200 | 68 | 4 | 64 | 2.94 |

Fig. 6

EP 2 398 150 B1

Fig. 7A

Fig. 7B

Fig. 7C

Fig. 7D

Fig. 7E

Fig. 7F

$L_1 = 2$

$m_{11}$ $m_{12}$ $m_{13}$ $m_{14}$

$S$ $S$

$L_2 = 3$

$m_{21}$ $m_{22}$ $m_{23}$ $m_{24}$ $m_{25}$

$S$ $S$ $S$

$L_N = 4$

$m_{N1}$ $m_{N2}$ $m_{N3}$

$S$ $S$ $S$ $S$

Fig. 7G

Fig. 8

Start

Erzeugen eines Datenstroms von zu
übertragenden Datenbits — S10

äußeres Kodieren der zu
übertragenden Datenbits — S20

Verschachteln und Verteilen der kodierten
Datenbits auf die einzelnen Blöcke — S30

inneres Kodieren und Modulieren der
einzelnen Blöcken zugewiesenen Datenbits
zu Datensymbolen, die auf einen zum Block
gehörigen Träger moduliert sind — S40

Zusammenfügen der auf dem zu den einzelnen
Blöcken jeweils gehörigen Trägern aufmodulierten
Datensymbolen zum Gesamtübertragungssignal — S50

Ende

Fig. 9

Start

Separieren der zu jeweils einem Block gehörigen
Datensymbole aus dem Gesamtübertragungssignal ⎯S100

Demodulieren und inneres Dekodieren der
zu den einzelnen Blöcken jeweils gehörigen
Datensymbole zu den einzelnen Blöcken jeweils
gehörigen Datenbits ⎯S110

Zusammenfügen der zu den einzelnen Blöcken
jeweils gehörigen Datenbits zu einem einzigen
Datenstrom und Entschachteln der einzelnen
Datenbits im Datenstrom ⎯S120

äußeres Dekodieren des Datenstroms
von empfangenen Datenbits ⎯S130

Ende

Fig. 10

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- EP 2136523 A2

### In der Beschreibung aufgeführte Nicht-Patentliteratur

- **FACHARTIKEL A. ; GUILLEN I FABREGAS.** Coded Modulation in the Block-Fading Channel: Coding Theorems and Code Construction. *IEEE Transactions on Information Theory,* Januar 2006, vol. 52 (1), 91-144

- **KHALED A.S. et al.** Analysis of Coding Schemes for Modulation and Error Control. *IEEE Transactions of Information Theory,* November 1995, vol. 41 (6